# EUROPEAN PATENT SPECIFICATION

(11) **EP 3 306 686 B1**
(45) Date of publication and mention of the grant of the patent: **03.07.2019**
(21) Application number: 16802757.1
(22) Date of filing: 16.05.2016
(51) Int. Cl.: H01L 35/28, H01L 35/32, H02N 11/00

(54) **ELECTRICITY GENERATING DEVICE AND THERMOELECTRIC MODULE**
STROMERZEUGUNGSVORRICHTUNG UND THERMOELEKTRISCHES MODUL
DISPOSITIF DE PRODUCTION D'ÉLECTRICITÉ ET MODULE THERMOÉLECTRIQUE

(30) Priority: 02.06.2015 JP 2015111880
(43) Date of publication of application: 11.04.2018
(73) Proprietor: Panasonic Intellectual Property Management Co., Ltd., Osaka-shi, Osaka 540-6207 (JP)
(72) Inventor: MIYAMOTO, Yutaka, Osaka-shi Osaka 540-6207 (JP); NAKAMURA, Shinji, Osaka-shi Osaka 540-6207 (JP)
(74) Representative: Vigand, Philippe
(86) International application number: PCT/JP2016/002372
(87) International publication number: WO 2016/194314

(56) References cited:
- EP-A2- 0 878 851
- WO-A1-83/03925
- JP-A- 2002 329 897
- JP-A- 2004 273 653
- JP-U- H0 379 459
- US-A- 3 632 451

## Description

### TECHNICAL FIELD

The present disclosure relates to an electricity generating device and a thermoelectric module using thermoelectric elements.

### BACKGROUND ART

Conventionally, a thermoelectric module using a thermoelectric element, and an electricity generating device using a thermoelectric module have been known. In such a thermoelectric module and an electricity generating device, electric power is generated by utilizing a thermal electromotive force generated by a temperature difference and the electric power is supplied to various electronic apparatuses and electrical machines to be used.

In such a conventional thermoelectric module or a conventional electricity generating device, a desired output voltage can be achieved by connecting a predetermined number of thermoelectric elements in series to structure a series unit for usage. Furthermore, a desired output current is achieved by connecting a predetermined numbers of series units in parallel for usage.

Note that, as prior art literatures related to the present application, for example, Patent Literature 1 and the like are known.

### Citation List

### Patent Literature

PTL 1: Unexamined Japanese Patent Publication No. 2010-10637

Furthermore, International application WO 83/03925 discloses an array of polarised energy-generating elements, e.g. batteries, thermoelectric generators, solar cells etc. which are arranged as a matrix having rows and columns of elements, with the elements in each row and column being polarised in the same direction.

EP 0 878 851 A2 shows a thermoelectric power generation apparatus in which thermoelectric modules are connected in series and in parallel.

US 3632451 discloses a thermoelectric device having parallel circuits interconnected at equal potential points.

Furthermore JP 2002 329897 A discloses a thermoelectric conversion element in which multiple p or n type semiconductors are alternately connected in series and are connected to adjacent semiconductors in parallel.

### SUMMARY OF THE INVENTION

An electricity generating device according an aspect of the present disclosure includes a first output terminal, a second output terminal, a first series unit connected between the first output terminal and the second output terminal, the first series unit being formed by connecting a plurality of first thermoelectric modules in series, a second series unit connected between the first output terminal and the second output terminal so as to be in parallel with the first series unit, the second series unit being formed by connecting a plurality of second thermoelectric modules in series, and a plurality of connection wirings connecting the first series unit and the second series unit. Then, the first series unit includes a plurality of first series wirings connecting the plurality of first thermoelectric modules in series, the second series unit includes a plurality of second series wirings connecting the plurality of second thermoelectric modules in series, and all the plurality of series wirings included in the first series unit and all the plurality of second series wirings included in the second series unit are connected by the plurality of corresponding respective connection wirings.

Furthermore, a thermoelectric module according to the present disclosure include a first output terminal, a second output terminal, a first substrate, a second substrate, a first series unit connected to the first output terminal and the second output terminal, the first series unit being formed by connecting a plurality of first thermoelectric elements in series via a plurality of first series wirings, a second series unit connected to the first output terminal and the second output terminal so as to be in parallel with the first series unit, the second series unit being formed by connecting a plurality of second thermoelectric elements in series via a plurality of second series wirings, and a plurality of connection wirings each connecting one of the plurality of first series wirings and one of the plurality of second series wirings. Then, the plurality of first series wirings and the plurality of second series wirings are arranged between the first substrate and the second substrate, and wherein all the plurality of series wirings included in the first series unit and all the plurality of second series wirings included in the second series unit are connected by the plurality of corresponding respective connection wirings.

### BRIEF DESCRIPTION OF DRAWINGS

FIG. 1 is a block diagram illustrating a configuration of an electricity generating device according to a first exemplary embodiment.
FIG. 2 is a block diagram illustrating a configuration of an electricity generating device according to a first modification of the first exemplary embodiment.
FIG. 3 is a block diagram illustrating a configuration of an electricity generating device according to a second modification of the first exemplary embodiment.
FIG. 4 is a block diagram illustrating a configuration of an electricity generating device according to a third modification of the first exemplary embodiment.
FIG. 5A is a perspective view of a thermoelectric module according to a second exemplary embodiment.
FIG. 5B is a perspective view of the thermoelectric module according to the second exemplary embodiment.
FIG. 6A is a wiring diagram of the thermoelectric module according to the second exemplary embodiment.
FIG. 6B is a wiring diagram of the thermoelectric module according to the second exemplary embodiment.
FIG. 7 is a circuit diagram illustrating a configuration of the thermoelectric module according to the second exemplary embodiment.

### DESCRIPTION OF EMBODIMENTS

Hereinafter, preferable exemplary embodiments of the present disclosure will be described with reference to drawings. Note that same reference numerals are attached to the same elements through all the drawings, and their overlapping description will be omitted.

### FIRST EXEMPLARY EMBODIMENT

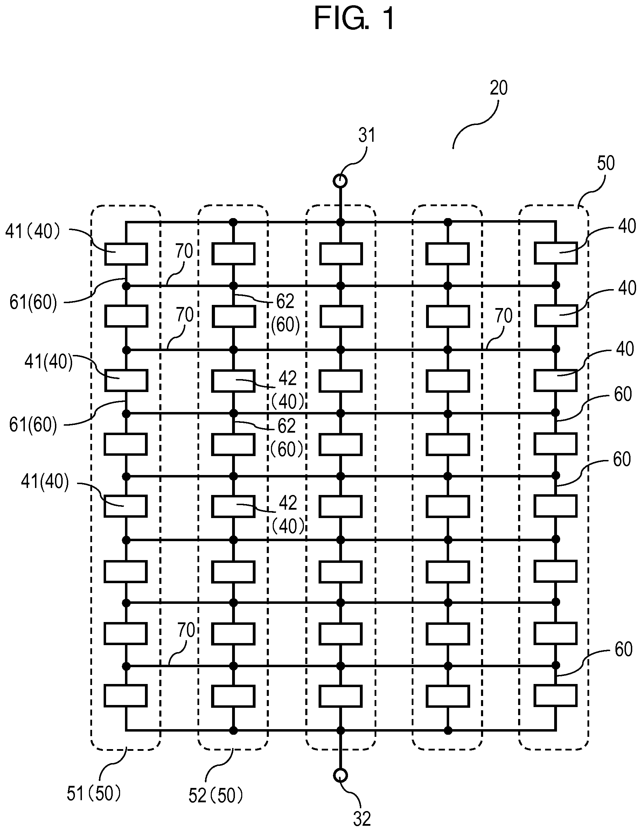

Hereinafter, an electricity generating device according to a first exemplary embodiment of the present disclosure will be described with reference to the drawings. FIG. 1 is a block diagram illustrating a configuration of electricity generating device 20 according to the first exemplary embodiment. Electricity generating device 20 includes a pair of output terminals 31, 32, and a plurality of series units 50 (including first series unit 51 and second series unit 52) each formed by connecting a plurality of thermoelectric modules 40 in series. Each of series units 50 is connected between the pair of output terminals 31, 32 in parallel with each other. In each of series units 50, thermoelectric modules 40 are connected in series via series wirings 60 (including first series wiring 61 and second series wiring 62). By such a configuration, electricity generating device 20 enables achievement of power generation voltage depending on a number of thermoelectric modules 40 connected in series, and enables achievement of power generation current depending on a number of series units 50 connected in parallel. Then, such a configuration enables achievement of an entire generated output depending on the number of thermoelectric modules 40 connected in series and the number of series units 50 connected in parallel.

Electricity generating device 20 according to the present exemplary embodiment is further provided with connection wirings 70 for connecting first series wiring 61 in first series unit 51 and second series wiring 62 in second series unit 52. Herein, first series unit 51 and second series unit 52 may be any series units 50 in electricity generating device 20. Furthermore, first series wiring 61 may be any series wiring 60 in first series unit 51, and second series wiring 62 may be any series wiring 60 in second series unit 52. Connection wirings 70 enable electricity generating device 20 to effectively utilize generated output of other thermoelectric modules 40 in series unit 50 to which disconnected thermoelectric module 40 belongs by having even when disconnection occurs in one of thermoelectric modules 40 in first series unit 51 or second series unit 52. This makes it possible to suppress a decrease of generated output.

That is, electricity generating device 20 includes output terminal 31, output terminal 32, series unit 51 connected to output terminal 31 and output terminal 32 and formed by connecting a plurality of thermoelectric modules 41 in series, series unit 52 connected to output terminal 31 and output terminal 32 so as to be in parallel with series unit 51 and formed by connecting a plurality of thermoelectric modules 42 in series, and a plurality of connection wirings 70 connecting series unit 51 and series unit 52. Series unit 51 includes a plurality of series wirings 61 connecting the plurality of thermoelectric modules 41 in series, and series unit 52 includes a plurality of series wirings 62 connecting the plurality of thermoelectric modules 42 in series. Then, each of the plurality of connection wirings 70 connects one of the plurality of series wirings 61 and one of the plurality of series wirings 62. Note that series unit 50 other than series unit 51 and series unit 52 may have the above configuration.

Generally, in electricity generating device 20 using a thermoelectric element, a reasonable temperature difference needs to be provided on both sides of the thermoelectric element in order to efficiently achieve an output power. Members for heating or cooling are disposed on a high temperature side and a low temperature side of electricity generating device 20, whole members of electricity generating device 20 are assembled and fitted and firmly fastened to increase adhesion between the members. Such a configuration reduces heat transfer loss in electricity generating device 20. However, an excessive stress is applied to the thermoelectric element and a substrate or the like structuring electricity generating device 20 due to a mechanical stress caused by handling or fitting pressure during assembling and fitting the members, a mechanical stress generated by a difference of a heat expansion coefficient or the like between the members during applying a temperature difference for electric generation, or the like. This may result in breaking of thermoelectric module 40 or disconnection of wiring. This results in one of reasons for a decrease in electric-generating capacity of thermoelectric module 40 and electricity generating device 20 using thermoelectric module 40.

A conventional electricity generating device does not have components corresponding to connection wirings 70 according to the present exemplary embodiment that connect between a plurality of series units. Therefore, when disconnection disadvantageously occurs inside one thermoelectric module 40, electric power supply from whole series unit 50 to which disconnected thermoelectric module 40 belongs is stopped, and generated output is drastically reduced.

In electricity generating device 20 according to the exemplary embodiment, by having connection wirings 70 connecting between the plurality of series units 50, even when disconnection occurs in one of thermoelectric module 40, other thermoelectric modules 40 of series unit 50 to which disconnected thermoelectric module 40 belongs are capable of supplying generated output. This makes it possible to suppress a decrease in generated output.

Specifically, in electricity generating device 20 according to the present exemplary embodiment, all series wirings 60 are connected in a grid manner by connection wirings 70. That is, supposing that n and m are natural numbers, electricity generating device 20 includes output terminals 31, 32, and (m + 1) series units each formed by connecting (n + 1) thermoelectric modules in series via n series wirings 60. (m + 1) series units 50 are connected to output terminals 31, 32 in parallel. Furthermore, supposing that k is a natural number from 1 to n, k-th series wirings 60 from output terminal 31 in respective (m + 1) series units are mutually connected via k-th connection wiring 70. Consequently, even when any one of the plurality of thermoelectric modules 40 is disconnected, electric power from all thermoelectric modules 40 excluding disconnected thermoelectric module 40 can be used. Therefore, a decrease in electric-generating capacity can be suppressed, and an amount of power generation can be stably secured.

That is, electricity generating device 20 of the present disclosure includes output terminal 31, output terminal 32, (m + 1) series units 50 each formed by connecting (n + 1) thermoelectric modules 40 in series via n series wirings 60, n and m being natural numbers, and the plurality of connection wirings 70. Then, (m + 1) series units 50 are connected in parallel between output terminal 31 and output terminal 32. Furthermore, supposing that k is a natural number from 1 to n, k-th arranged series wirings 60 from a side of output terminal 31 among n series wirings 60 in (m + 1) series units 50 are mutually connected via k-th arranged connection wiring 70 from the side of output terminal 31 among the plurality of connection wirings 70.

Furthermore, in electricity generating device 20, all first series wirings 61 in first series unit 51 and all second series wirings 62 in second series unit 52 are connected by corresponding respective connection wirings 70. This configuration makes it possible to utilize electric power of all other thermoelectric modules 40 that are not disconnected even when any one of thermoelectric modules 40 in the first series unit 51 and second series unit 52 is disconnected. Thus, a decrease in electric-generating capacity can be suppressed.

That is, in electricity generating device 20, all the plurality of series wirings 61 included in first series unit 51 and all the plurality of second series wirings 62 included in the second series unit 52 are connected by the plurality of corresponding respective connection wirings 70.

### First Modification of First Exemplary Embodiment

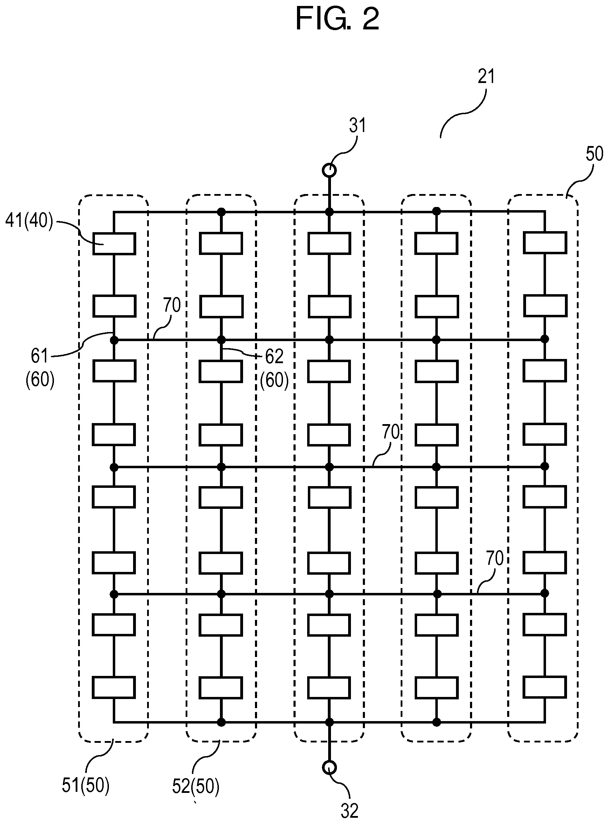

FIG. 2 is a block diagram illustrating a configuration of electricity generating device 21 according to a first modification of the first exemplary embodiment of the present disclosure. In electricity generating device 21 illustrated in FIG. 2, first series unit 51 and second series unit 52 have a same number of thermoelectric modules 40, and supposing that one of the pair of output terminals 31, 32 is output terminal 31, a number of thermoelectric modules 40 connected from output terminal 31 to connection wiring 70 via first series unit 51 is equal to a number of thermoelectric modules 40 connected from output terminal 31 to connection wiring 70 via second series unit 52. Such a configuration enables electricity generating device 21 to make a thermal electromotive force of first series unit 51 from connection wiring 70 to first output terminal 31 be equivalent to a thermal electromotive forces of second series unit 52 from connection wiring 70 to first output terminal 31. As a result, loss by a circulation current can be reduced. This makes it possible to more effectively suppress a decrease in generated output during failure of thermoelectric module 40.

That is, in electricity generating device 21 of the present modification, the number of the plurality of thermoelectric modules 40 included in first series unit 51 is equal to the number of the plurality of thermoelectric modules 40 included in second series unit 52. Furthermore, a number of the plurality of thermoelectric modules 40 connected from output terminal 31 to connection wiring 70 via first series unit 51 is equal to a number of the plurality of thermoelectric modules 40 connected from output terminal 31 to same connection wiring 70 via second series unit 52.

### Second Modification of First Exemplary Embodiment

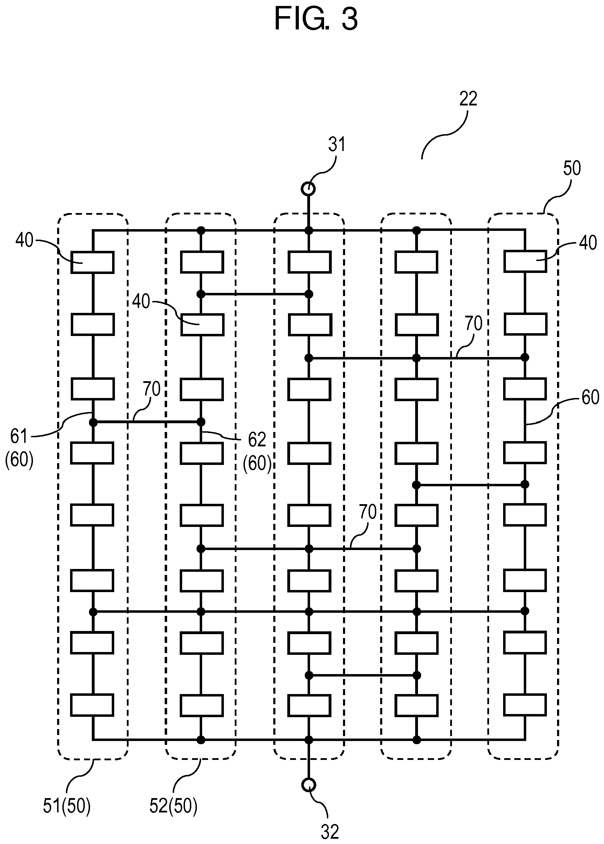

FIG. 3 is a block diagram illustrating a configuration of electricity generating device 22 according to a second modification of the first exemplary embodiment of the present disclosure. Electricity generating device 22 illustrated in FIG. 3 includes, in any first series unit 51 and any second series unit 52 among the plurality of series units 50, connection wiring 70 connecting any first series wiring 61 in first series unit 51 and any second series wiring 62 in second series unit 52. Electricity generating device 22 having connection wiring 70 is capable of effectively utilizing generated output of other thermoelectric modules 40 in series unit 50 to which disconnected thermoelectric module 40 belongs even when disconnection is occurred in one of thermoelectric modules 40 in first series unit 51 or second series unit 52. Electricity generating device 22 of the present exemplary embodiment thus makes it possible to suppress a decrease in generated output. The configuration of connection wiring 70 in electricity generating device 22 is effective in a case where all series wirings 60 cannot be arranged in a grid manner due to configuration of the device.

### Third Modification of First Exemplary Embodiment

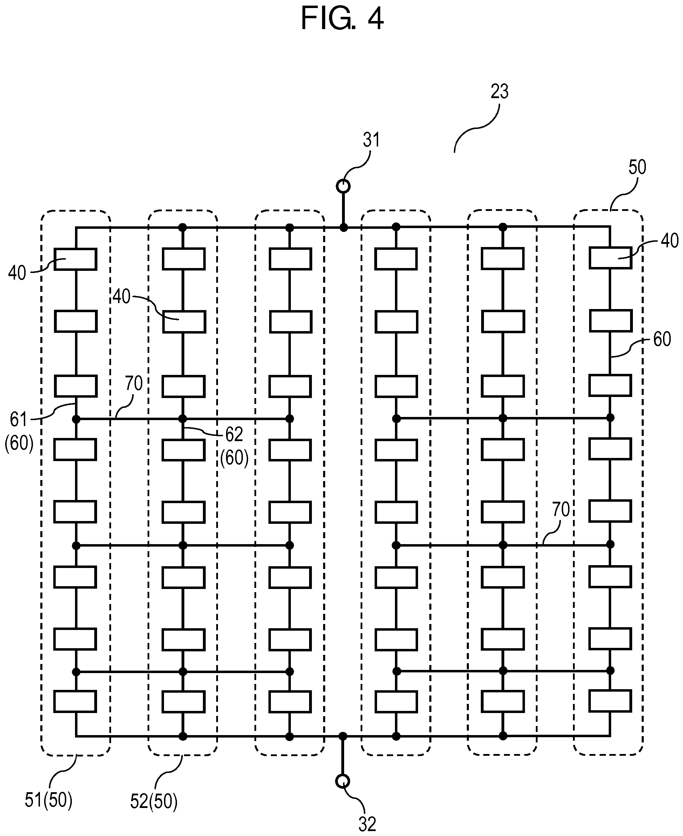

FIG. 4 is a block diagram illustrating a configuration of electricity generating device 23 according to a third modification of the first exemplary embodiment of the present disclosure. In electricity generating device 23, first series wiring 61 of first series unit 51 and second series wiring 62 of second series unit 52 are connected by connection wiring 70. Furthermore, in electricity generating device 23, first series unit 51 and second series unit 52 have equivalent thermal electromotive forces, and supposing that one of a pair of output terminals 31, 32 is first output terminal 31, a magnitude of the thermal electromotive force from first output terminal 31 to connection wiring 70 via first series unit 51 is made to be equivalent to a magnitude of the thermal electromotive force from first output terminal 31 to connection wiring 70 via second series unit 52. That is, first series unit 51 and second series unit 52 have equivalent thermal electromotive forces, and a magnitude of the thermal electromotive force from output terminal 31 to connection wiring 70 via first series unit 51 and a magnitude of the thermal electromotive force from output terminal 31 to same connection wiring 70 via second series unit 52 are equivalent.

Herein, that the thermal electromotive forces are equivalent denotes that a magnitude of thermal electromotive force of one is within a range of ± 10% of a magnitude of thermal electromotive force of the other one. That is, "equivalent" also includes substantially equivalent (included within the range of ± 10%). Having such a configuration enables electricity generating device 23 to reduce loss by a circulation current, and making it possible to more effectively suppress a decrease in generated output during failure of thermoelectric module 40. When a continual temperature variation occurs in electricity generating device 23, it is not necessarily most efficient that connection wirings 70 are arranged in a grid manner, or a numbers of thermoelectric modules 40 from output terminal 31, 32 to connection wiring 70 are made to be constant. In such a case, it is preferable that connection wirings 70 be provided at positions where make substantive electromotive forces become equivalent from a viewpoint of making output of electricity generating device 23 become maximum.

Furthermore, in electricity generating device 23, it is preferable that first series unit 51 and second series unit 52 have equivalent thermal electromotive forces, and supposing that one of the pair of output terminals 31, 32 is first output terminal 31, a magnitude of generated output from first output terminal 31 to connection wiring 70 via first series unit 51 is made to be equivalent to a magnitude of generated output from first output terminal 31 to connection wiring 70 via second series unit 52. That is, first series unit 51 and second series unit 52 have equivalent thermal electromotive forces, and a magnitude of generated output from output terminal 31 to connection wiring 70 via first series unit 51 is equivalent to a magnitude of generated output from output terminal 31 to same connection wiring 70 via second series unit 52. That is, "equivalent" also includes substantially equivalent (included within the range of ± 10%). Herein, that "generated outputs are equivalent" denotes that a magnitude of generated output of one is within a range of ± 10% of a magnitude of generated output of the other one. Having such a configuration enables electricity generating device 23 to more effectively suppress a decrease in generated output during failure of thermoelectric module 40.

Note that arrangements of connection wirings 70 illustrated in the present disclosure are not limited to the configurations illustrated in the drawings. Any connection configuration may be available as long as the connection configuration makes it possible to suppress a decrease or stoppage of total electric power by outputting electric power of other normal thermoelectric elements via connection wiring 70 provided between another series unit 50 connected in parallel when a thermoelectric element is broken down in series unit 50.

### SECOND EXEMPLARY EMBODIMENT

Hereinafter, thermoelectric module 80 according to a second exemplary embodiment of the present disclosure will be described with reference to drawings.

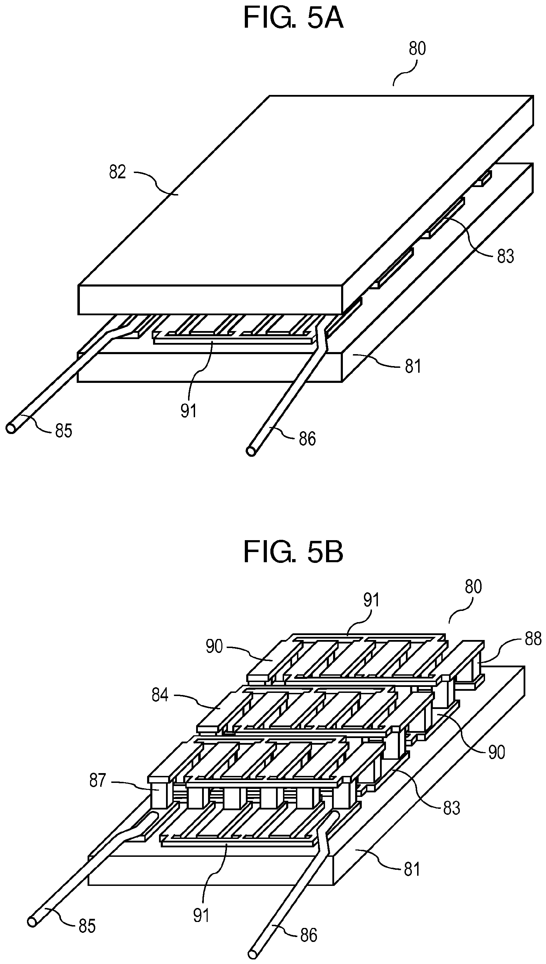

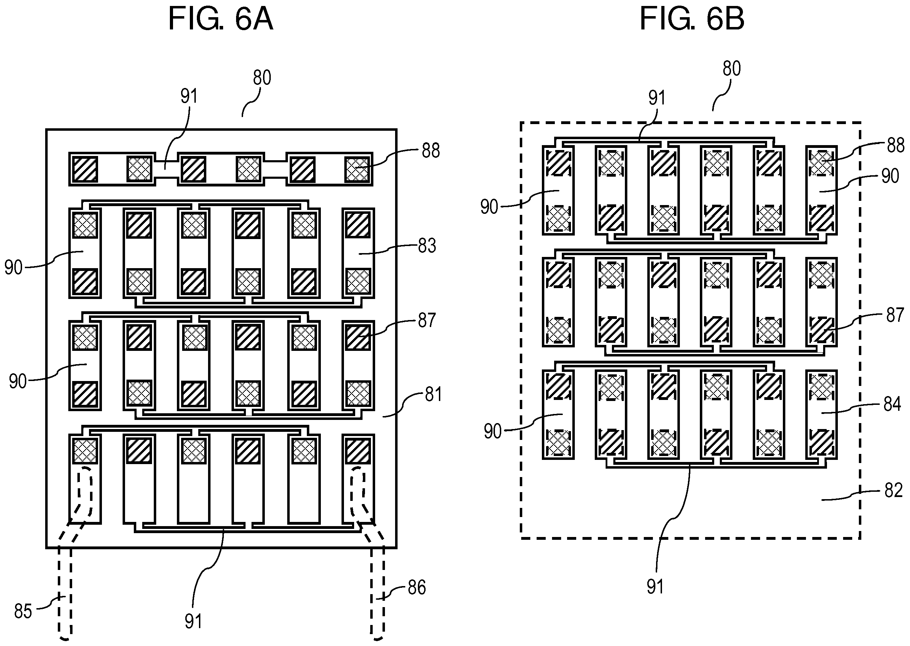

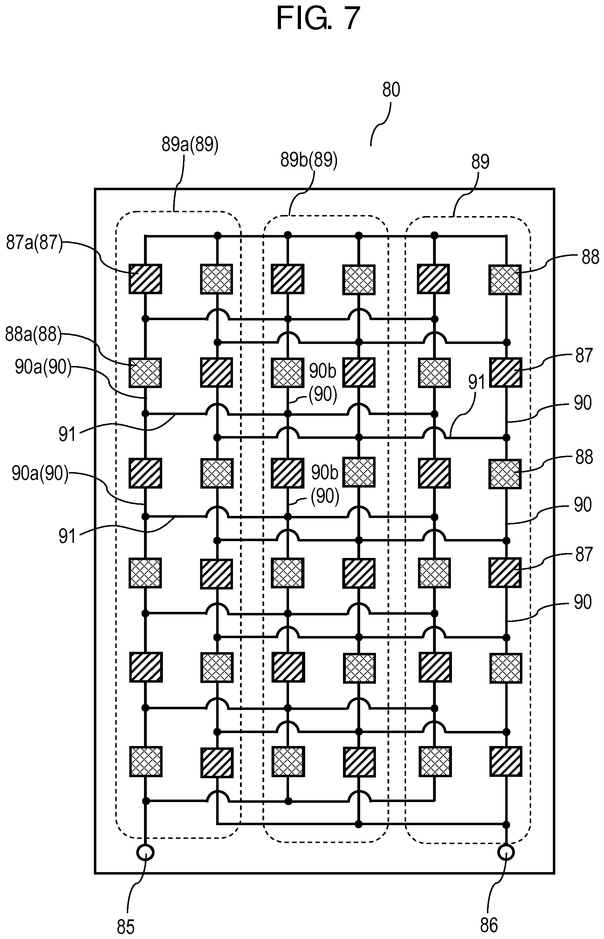

FIG. 5A is a perspective view of thermoelectric module 80 according to the second exemplary embodiment. FIG. 5B is a perspective view illustrating an inner configuration of thermoelectric module 80 according to the second exemplary embodiment, and illustrating a state where substrate 82 on an upper side of thermoelectric module 80 illustrated in FIG. 5A is removed. In FIG. 5A and FIG. 5B, thermoelectric module 80 includes a pair of substrates 81, 82, electrodes 83, 84 respectively formed on surfaces of substrates 81, 82, thermoelectric elements 87, 88 formed between electrodes 83, 84, and a pair of output terminals 85, 86. FIG. 6A illustrates a wiring diagram of electrodes 83 formed on an upper surface of substrate 81 on the lower side of thermoelectric module 80. In FIG. 6A, output terminals 85, 86 are illustrated by broken lines. FIG. 6B illustrates a wiring diagram in which electrodes 84 formed on a lower surface of substrate 82 on the upper side of thermoelectric module 80 are seen through from an upper side. In FIG. 6B, substrate 82 and thermoelectric elements 87, 88 are illustrated by broken lines. FIG. 7 is a circuit diagram of thermoelectric module 80.

As substrates 81, 82, for example, a metal substrate in which copper is its main component, a ceramic substrate using aluminum oxide, or a flexible substrate is usable. Electrodes 83 are conductors formed on the upper surface of substrate 81, and electrodes 84 are conductors formed on the lower surface of substrate 82. Electrodes 83 and electrodes 84 each are, for example, formed by a metal such as copper. Thermoelectric elements 87 each are a P-type thermoelectric conversion element, and thermoelectric elements 88 each are an N-type thermoelectric conversion element. Thermoelectric elements 87 and thermoelectric elements 88 generate thermal electromotive forces in reverse directions by a temperature difference between their both ends. Thermoelectric elements 87 and thermoelectric elements 88 are alternately wired and connected between electrodes 83, 84, and generate thermal electromotive forces in a same direction by providing a temperature difference in reverse directions. Output terminals 85, 86 are lead wires connected at ends of electrodes 83, and for example, formed by a metal such as a copper line.

Thermoelectric module 80 further includes a sealant (not illustrated) for sealing electrodes 83, 84 and thermoelectric elements 87, 88 between substrates 81, 82.

As illustrated in the circuit diagram of FIG. 7, thermoelectric module 80 includes the pair of output terminals 85, 86 and a plurality of series units 89, and the plurality of series units 89 is connected in parallel between the pair of output terminals 85, 86. Then, series wiring 90 connecting thermoelectric elements 87, 88 in series in each of series units 89 is connected with series wiring 90 of another series unit 89 by connection wiring 91. Herein, one of the plurality of series units 89 shall be first series unit 89a, and another one thereof shall be second series unit 89b. Then, series wiring 90 connecting thermoelectric elements 87, 88 in series in first series unit 89a shall be first series wiring 90a, and series wiring 90 connecting thermoelectric elements 87, 88 in series in second series unit 89b shall be second series wiring 90b. Thermoelectric module 80 includes connection wirings 91 that connect first series wiring 90a and second series wiring 90b. Thermoelectric module 80 makes it possible to effectively output electric power of thermoelectric elements 87, 88 that are not disconnected by having connection wirings 91 even when disconnection occurs in any of thermoelectric elements 87, 88. Thermoelectric module 80 according to the present exemplary embodiment thus makes it possible to suppress a decrease in electric-generating capacity caused by failure of thermoelectric element 87, 88.

That is, thermoelectric module 80 includes output terminal 85, output terminal 86, substrate 81, substrate 82, first series unit 89a connected to output terminal 85 and output terminal 86 and formed by connecting a plurality of thermoelectric elements 87, 88 in series via a plurality of series wirings 90a, second series unit 89b connected to output terminal 85 and output terminal 86 so as to be in parallel with series unit 89a and formed by connecting a plurality of thermoelectric elements 87, 88 in series via a plurality of series wiring 90b, and a plurality of connection wirings 91 each connecting one of the plurality of series wirings 90a and one of the plurality of series wirings 90b. Then, the plurality of series wirings 90a and the plurality of series wirings 90b are arranged between substrate 81 and substrate 82.

Note that when connection wiring 91 is arranged, portions between any series wirings 90 in different series units 89 are connectable by connection wiring 91. This configuration enables thermoelectric module 80 according to the present exemplary embodiment to suppress a decrease in generated output during failure of thermoelectric element 87, 88.

Furthermore, in thermoelectric module 80, first series unit 89a and second series unit 89b among the plurality of series units 89 shall have an equal number of thermoelectric elements 87, 88, and a number of thermoelectric elements 87, 88 in first series unit 89a is made to be equal to a number of thermoelectric elements 87, 88 in second series unit 89b from one of output terminals 85, 86 to each of connection wirings 91. That is, in thermoelectric module 80, a number of the plurality of thermoelectric elements 87, 88 included in series unit 89a is equal to a number of the plurality of thermoelectric elements 87, 88 included in series unit 89b. Then, a number of thermoelectric elements 87, 88 from output terminal 85 (or output terminal 86) to connection wiring 91 via series unit 89a is equal to a number of thermoelectric elements 87, 88 from output terminal 85 (or output terminal 86) to the same connection wiring 91 via series unit 89b.

Since this configuration makes it possible to equalize a thermal electromotive force from one of output terminals 85, 86 to connection wiring 91, and thus generated output of thermoelectric module 80 can be maximum. Therefore, a decrease in generated output during failure of thermoelectric element 87, 88 can be more effectively suppressed.

Furthermore, thermoelectric module 80 is configured so that all series wirings 90 connecting between thermoelectric elements 87, 88 in series units 89 are connected in a grid manner by connection wirings 91. That is, supposing that n and m are natural numbers and one of output terminals 85, 86 is first output terminal 85 and the other one is second terminal 86, thermoelectric module 80 includes m + 1 series units 89 each formed by connecting (n + 1) thermoelectric elements 87, 88 in series via n series wirings 90, (m + 1) series units 89 are connected in parallel between first output terminal 85 and second output terminal 86. Further, supposing that k is a natural number from 1 to n, k-th series wirings 90 from first output terminal 85 in respective (m + 1) series units 89 are mutually connected via k-th connection wiring 91 from first output terminal 85. This makes it possible to effectively utilize all remaining thermoelectric elements 87, 88 that are not disconnected even when any one of thermoelectric elements 87, 88 is disconnected, and thus a decrease in output power of thermoelectric module 80 can be effectively suppressed.

Note that, in thermoelectric module 80, although being formed by using electrode 83 on the upper surface of substrate 81 and electrode 84 on the lower surface of substrate 82, connection wiring 91 may be formed by another method. For example, connection wiring 91 can be provided inside substrate 81 and substrate 82 as an inner layer electrode. Alternatively, an insulating film can be formed on a portion of surfaces of electrode 83 and electrode 84, and connection wiring 91 can be provided so as to be a three-dimensional cross wiring with respect to electrode 83 and electrode 84. In thermoelectric module 80, connection wirings 91 are formed on same planes as series wirings 90 by using electrodes 83 arranged on the upper surface of substrate 81 and electrodes 84 arranged on the lower surface of substrate 82. That is, the plurality of connection wirings 91 is formed in a layer in which the plurality of series wirings 90 is arranged. Consequently, no inner layer electrode needs to be provided on substrates 81, 82, and no additional insulating layer or conductive layer for forming a three-dimensional cross wiring needs to be formed.

Consequently, thermoelectric module 80 according to the present exemplary embodiment makes it possible to suppress a decrease in output power of thermoelectric module 80 during disconnection of thermoelectric element 87, 88 without adding manufacturing steps and components too much, resulting in having manufacturing and economic advantages. Herein, a same plane in which connection wiring 91 and series wiring 90 are formed does not necessarily denote an absolutely same plane. For example, like in a case where substrate 81 and substrate 82 are flexible substrates, the above case includes a case where a surface is an uneven surface or a curved surface, and a case where connection wiring 91 and series wiring 90 are formed in a same layer.

According to the present disclosure, the electricity generating device and the thermoelectric module make it possible to cause output of other normal thermoelectric elements connected to a damaged thermoelectric element in series to be output via other series units connected in parallel. Therefore, the electricity generating device and the thermoelectric module of the present disclosure make it possible to suppress a decrease in electric-generating capacity due to failure of a thermoelectric element.

### INDUSTRIAL APPLICABILITY

The present disclosure makes it possible to suppress a decrease or stoppage of generated output due to a failure of an electricity generating device using thermoelectric elements with a simple configuration. Therefore, in the present disclosure, an electricity generating device using thermoelectric elements makes it possible to suppress a decrease in generated output simply and inexpensively, and thus can provide improvement of generated output and improvement of quality. The electricity generating device and the thermoelectric module of the present disclosure are useful as a power supply source to various electronic apparatuses.

### REFERENCE MARKS IN THE DRAWINGS

- 20, 21, 22, 23: electricity generating device
- 31, 32: output terminal
- 40, 41, 42: thermoelectric module
- 50, 51, 52: series unit
- 60, 61, 62: series wiring
- 70: connection wiring
- 80: thermoelectric module
- 81, 82: substrate
- 83, 84: electrode
- 85, 86: output terminal
- 87, 88: thermoelectric element
- 89, 89a, 89b: series unit
- 90, 90a, 90b: series wiring
- 91: connection wiring

## Claims

1. An electricity generating device (20) comprising:
a first output terminal (31);
a second output terminal (32);
a first series unit (51) connected between the first output terminal (31) and the second output terminal (32), the first series unit (51) being formed by connecting a plurality of first thermoelectric modules (41) in series;
a second series unit (52) connected between the first output terminal (31) and the second output terminal (32) so as to be in parallel with the first series unit (51), the second series unit (52) being formed by connecting a plurality of second thermoelectric modules (42) in series; and
a plurality of connection wirings (70) connecting the first series unit (51) and the second series unit (52),
wherein
the first series unit (51) includes a plurality of first series wirings (61) connecting the plurality of first thermoelectric modules (41) in series,
the second series unit (52) includes a plurality of second series wirings (62) connecting the plurality of second thermoelectric modules (42) in series,
**characterized in that**
all the plurality of series wirings (61) included in the first series unit (51) and all the plurality of second series wirings (62) included in the second series unit (52) are connected by the plurality of corresponding respective connection wirings (70).

2. The electricity generating device according to claim 1, wherein
the first series unit (51) and the second series unit (52) have equivalent thermal electromotive forces,
the plurality of connection wirings includes a first connection wiring, and
a magnitude of a thermal electromotive force from the first output terminal (31) to the first connection wiring via the first series unit (51) is equivalent to a magnitude of a thermal electromotive force from the first output terminal (31) to the first connection wiring via the second series unit (52).

3. The electricity generating device according to claim 1, wherein
the first series unit (51) and the second series unit (52) have equivalent thermal electromotive forces,
the plurality of connection wirings includes a first connection wiring, and
a magnitude of a generated output from the first output terminal (31) to the first connection wiring via the first series unit (51) is equivalent to a magnitude of a generated output from the first output terminal (31) to the first connection wiring via the second series unit (52).

4. A thermoelectric module (80) comprising:
a first output terminal (85);
a second output terminal (86);
a first substrate (81);
a second substrate (82)
a first series unit (89a) connected to the first output terminal (85) and the second output terminal (86), the first series unit (89a) being formed by connecting a plurality of first thermoelectric elements (87) in series via a plurality of first series wirings (90a);
a second series unit (89b) connected to the first output terminal (85) and the second output terminal (86) so as to be in parallel with the first series unit (89a), the second series unit (89b) being formed by connecting a plurality of second thermoelectric elements (88) in series via a plurality of second series wirings (90b); and
a plurality of connection wirings (91) each connecting one of the plurality of first series wirings and one of the plurality of second series wirings,
wherein
the plurality of first series wirings and the plurality of second series wirings are arranged between the first substrate and the second substrate, and
wherein
all the plurality of series wirings (90a) included in the first series unit (89a) and all the plurality of second series wirings (90b) included in the second series unit (89b) are connected by the plurality of corresponding respective connection wirings (91).

5. The thermoelectric module according to claim 4, wherein the plurality of connection wirings (91) is formed in a layer in which the plurality of first series wirings (90a) is arranged.

## Patentansprüche

1. Stromerzeugungsvorrichtung (20), umfassend:
eine erste Ausgangsklemme (31);
eine zweite Ausgangsklemme (32);
ein erstes Seriengerät (51), das zwischen der ersten Ausgangsklemme (31) und der zweiten Ausgangsklemme (32) verbunden ist, wobei das erste Seriengerät (51) durch Verbinden einer Mehrzahl von ersten thermoelektrischen Modulen (41) in Reihe gebildet wird;
ein zweites Seriengerät (52), das zwischen der ersten Ausgangsklemme (31) und der zweiten Ausgangsklemme (32) so verbunden ist, dass es parallel zum ersten Seriengerät (51) ist, wobei das zweite Seriengerät (52) durch Verbinden einer Mehrzahl von zweiten thermoelektrischen Modulen (42) in Reihe gebildet wird, und
eine Mehrzahl von Verbindungsverdrahtungen (70), die das erste Seriengerät (51) und das zweite Seriengerät (52) verbinden,
wobei das erste Seriengerät (51) eine Mehrzahl von ersten Serienverdrahtungen (61) aufweist, die die Mehrzahl der ersten thermoelektrischen Module (41) in Serie verbinden,
das zweite Seriengerät (52) eine Mehrzahl von zweiten Serienverdrahtungen (62) aufweist, die die Mehrzahl der zweiten thermoelektrischen Module (42) in Serie verbinden,
**dadurch gekennzeichnet,**
**dass** die gesamte Mehrzahl von Reihenverdrahtungen (61), die im ersten Seriengerät (51) enthalten sind, und die gesamte Mehrzahl von Reihenverdrahtungen (62), die im zweiten Seriengerät (52) enthalten sind, durch die Mehrzahl von entsprechenden jeweiligen Verbindungsverdrahtungen (70) verbunden sind.

2. Stromerzeugungsvorrichtung nach Anspruch 1, wobei
das erste Seriengerät (51) und das zweite Seriengerät (52) gleichwertige thermische elektromotorische Kräfte aufweisen,
die Mehrzahl von Verbindungsverdrahtungen eine erste Verbindungsverdrahtung aufweist, und
eine Größe einer thermischen elektromotorischen Kraft von der ersten Ausgangsklemme (31) zur ersten Verbindungsverdrahtung über das erste Seriengerät (51) einer Größe einer thermischen elektromotorischen Kraft von der ersten Ausgangsklemme (31) zur ersten Verbindungsverdrahtung über das zweite Seriengerät (52) entspricht.

3. Stromerzeugungsvorrichtung nach Anspruch 1, wobei
das erste Seriengerät (51) und das zweite Seriengerät (52) gleichwertige thermische elektromotorische Kräfte aufweisen,
die Mehrzahl von Verbindungsverdrahtungen eine erste Verbindungsverdrahtung aufweist, und
eine Größe einer erzeugten Ausgabe von der ersten Ausgangsklemme (31) zur ersten Verbindungsverdrahtung über das erste Seriengerät (51) gleich einer Größe einer erzeugten Ausgabe von der ersten Ausgangsklemme (31) zur ersten Verbindungsverdrahtung über das zweite Seriengerät (52) ist.

4. Thermoelektrisches Modul (80), das Folgendes umfasst:
eine erste Ausgangsklemme (85);
eine zweite Ausgangsklemme (86);
ein erstes Substrat (81);
ein zweites Substrat (82),
ein erstes Seriengerät (89a), das mit der ersten Ausgangsklemme (85) und der zweiten Ausgangsklemme (86) verbunden ist, wobei das erste Seriengerät (89a) durch Verbinden einer Mehrzahl von ersten thermoelektrischen Elementen (87) in Reihe über eine Mehrzahl von ersten Serienverdrahtungen (90a) gebildet wird;
ein zweites Seriengerät (89b), das mit der ersten Ausgangsklemme (85) und der zweiten Ausgangsklemme (86) verbunden ist, um parallel zum ersten Seriengerät (89a) zu sein, wobei das zweite Seriengerät (89b) durch Verbinden einer Mehrzahl von zweiten thermoelektrischen Elementen (88) in Reihe über eine Mehrzahl von zweiten Reihenverdrahtungen (90b) gebildet wird; und
eine Mehrzahl von Verbindungsverdrahtungen (91), die jeweils eine der Mehrzahl von ersten Reihenverdrahtungen und eine der Mehrzahl von zweiten Reihenverdrahtungen verbinden,
wobei
die Mehrzahl von ersten Reihenverdrahtungen und die Mehrzahl von zweiten Reihenverdrahtungen zwischen dem ersten Substrat und dem zweiten Substrat angeordnet ist, und
wobei
die gesamte Mehrzahl von Reihenverdrahtungen (90a), die im ersten Seriengerät (89a) enthalten sind, und die gesamte Mehrzahl von zweiten Reihenverdrahtungen (90b), die im zweiten Seriengerät (89b) enthalten sind, durch die Mehrzahl von entsprechenden jeweiligen Verbindungsverdrahtungen (91) verbunden ist.

5. Thermoelektrisches Modul nach Anspruch 4,
wobei die Mehrzahl von Verbindungsverdrahtungen (91) in einer Schicht gebildet ist, in der die Mehrzahl von ersten Serienverdrahtungen (90a) angeordnet ist.

## Revendications

1. Dispositif de production d'électricité (20) comprenant :
une première borne de sortie (31) ;
une seconde borne de sortie (32) ;
une première unité en série (51) connectée entre la première borne de sortie (31) et la seconde borne de sortie (32), la première unité en série (51) étant formée par connexion d'une pluralité de premiers modules thermoélectriques (41) en série ;
une seconde unité en série (52) connectée entre la première borne de sortie (31) et la seconde borne de sortie (32) de manière à être en parallèle avec la première unité en série (51), la seconde unité en série (52) étant formée par connexion d'une pluralité de seconds modules thermoélectriques (42) en série ; et
une pluralité de câblages de connexion (70) connectant la première unité en série (51) et la seconde unité en série (52), dans lequel :
la première unité en série (51) comporte une pluralité de premiers câblages en série (61) connectant la pluralité de premiers modules thermoélectriques (41) en série,
la seconde unité en série (52) comporte une pluralité de seconds câblages en série (62) connectant la pluralité de seconds modules thermoélectriques (42) en série,
**caractérisé en ce que** :
toute la pluralité de câblages en série (61) incluse dans la première unité en série (51) et toute la pluralité de seconds câblages en série (62) incluse dans la seconde unité en série (52) sont connectées par la pluralité de câblages de connexion respectifs correspondants (70).

2. Dispositif de production d'électricité selon la revendication 1, dans lequel :
la première unité en série (51) et la seconde unité en série (52) ont des forces électromotrices thermiques équivalentes,
la pluralité de câblages de connexion comporte un premier câblage de connexion, et
une grandeur de force électromotrice thermique de la première borne de sortie (31) au premier câblage de connexion par le biais de la première unité en série (51) est équivalente à une grandeur de force électromotrice thermique de la première borne de sortie (31) au premier câblage de connexion par le biais de la seconde unité en série (52).

3. Dispositif de production d'électricité selon la revendication 1, dans lequel :
la première unité en série (51) et la seconde unité en série (52) ont des forces électromotrices thermiques équivalentes,
la pluralité de câblages de connexion comporte un premier câblage de connexion, et
une grandeur de sortie produite de la première borne de sortie (31) au premier câblage de connexion par le biais de la première unité en série (51) est équivalente à une grandeur de sortie produite de la première borne de sortie (31) au premier câblage de connexion par le biais de la seconde unité en série (52).

4. Module thermoélectrique (80) comprenant :
une première borne de sortie (85) ;
une seconde borne de sortie (86) ;
un premier substrat (81) ;
un second substrat (82) ;
une première unité en série (89a) connectée à la première borne de sortie (85) et à la seconde borne de sortie (86), la première unité en série (89a) étant formée par connexion d'une pluralité de premiers éléments thermoélectriques (87) en série par le biais d'une pluralité de premiers câblages en série (90a) ;
une seconde unité en série (89b) connectée à la première borne de sortie (85) et à la seconde borne de sortie (86) de manière à être en parallèle avec la première unité en série (89a), la seconde unité en série (89b) étant formée par connexion d'une pluralité de seconds éléments thermoélectriques (88) en série par le biais d'une pluralité de seconds câblages en série (90b) ; et
une pluralité de câblages de connexion (91) connectant chacun un câblage de la pluralité de premiers câblages en série à un câblage de la pluralité de seconds câblages en série,
dans lequel :
la pluralité de premiers câblages en série et la pluralité de seconds câblages en série sont disposées entre le premier substrat et le second substrat, et
dans lequel :
toute la pluralité de câblages en série (90a) incluse dans la première unité en série (89a) et toute la pluralité de seconds câblages en série (90b) incluse dans la seconde unité en série (89b) sont connectées par la pluralité de câblages de connexion respectifs correspondants (91).

5. Module thermoélectrique selon la revendication 4, dans lequel la pluralité de câblages de connexion (91) est formée dans une couche dans laquelle est disposée la pluralité de premiers câblages en série (90a).
